# EUROPEAN PATENT APPLICATION

(11) **EP 4 503 111 A1**
(43) Date of publication of application: **05.02.2025**
(21) Application number: 22933592.2
(22) Date of filing: 28.09.2022
(51) Int. Cl.: H01L 21/768, H01L 23/532

(54) **SUBSTRATE PROCESSING METHOD AND SUBSTRATE PROCESSING DEVICE**

(30) Priority: 25.03.2022 JP 2022050084
(71) Applicant: SCREEN Holdings Co., Ltd., Kyoto-shi, Kyoto 602-8585 (JP)
(72) Inventor: YOSHIDA, Yukifumi, Kyoto-shi, Kyoto 602-8585 (JP); MIYAMOTO, Yasuharu, Kyoto-shi, Kyoto 602-8585 (JP)
(74) Representative: Goddar, Heinz J.
(86) International application number: PCT/JP2022/036192
(87) International publication number: WO 2023/181462

(57) **Abstract**

Provided are a substrate treating method and a substrate treating apparatus capable of selectively forming a self-assembled monolayer as a protective film while suppressing etching of a metal film on a substrate. A substrate treating method of the present invention is a substrate treating method for treating a substrate including, on a surface, a metal film formed region where a metal film 1 is formed and a metal film non-formed region where the metal film 1 is not formed, the substrate treating method comprising: a dissolved oxygen concentration reduction step of reducing a dissolved oxygen concentration of a treating liquid containing a material for forming a self-assembled monolayer 4; and a self-assembled monolayer forming step of forming the self-assembled monolayer 4 on the metal film 1 in the metal film formed region while suppressing oxidation of the metal film 1 by bringing the treating liquid after the dissolved oxygen concentration reduction step at least into contact with the surface of the substrate.

## Description

### TECHNICAL FIELD

The present invention relates to a substrate treating method and a substrate treating apparatus capable of favorably performing selective film formation.

### BACKGROUND ART

In the manufacture of a semiconductor device, a photolithography technique is widely used as a technique for selectively forming a film in a specific surface region of a substrate. For example, an insulating film is formed after underlayer wiring is formed, a dual damascene structure having a trench and a via hole is formed by photolithography and etching, and a conductive film of such as Cu is embedded in the trench and the via hole to form a wiring.

However, in recent years, miniaturization of semiconductor devices has progressed more and more, and alignment accuracy is not sufficient in the photolithography technique in some cases. For this reason, instead of the photolithography technique, a method of selectively forming a film with high accuracy in a specific region on the substrate surface has been demanded.

For example, Patent Document 1 discloses a film forming method in which a self-assembled monolayer (SAM) is formed on the surface of a substrate region where film formation is not desired, and a film is selectively formed on the substrate region where the SAM is not formed. By this film forming method, by using a solvent having an optimum dielectric constant, more specifically, a mixed solvent composed of propylene glycol monomethyl ether (PGME) and propylene glycol monomethyl ether acetate (PGMEA) as a treating liquid for forming a SAM, it is possible to suppress a decrease in the coverage of the SAM and to prevent a decrease in selectivity of the treating solution to a metal film.

However, the film forming method disclosed in Patent Document 1 has a problem that the metal film is etched when the SAM is formed on the metal film made of copper, for example.

### PRIOR ART DOCUMENT

### PATENT DOCUMENT

Patent Document 1: US 10,867,850

### SUMMARY OF THE INVENTION

### PROBLEMS TO BE SOLVED BY THE INVENTION

The present invention has been made in view of the above problem, and an object thereof is to provide a substrate treating method and a substrate treating apparatus capable of selectively forming a self-assembled monolayer as a protective film while suppressing etching of a metal film on a substrate.

### SOLUTIONS TO THE PROBLEMS

The present invention has been completed with the idea that etching of a metal film when a self-assembled monolayer (SAM) is formed in a metal film formed region of a substrate surface is caused by a dissolved oxygen concentration of a treating liquid for forming a SAM. That is, it is based on the finding that when the dissolved oxygen concentration in the treating liquid is too high, as a result of the dissolved oxygen oxidizing the metal film, the metal constituting the metal film is dissolved in the treating liquid, whereby the metal film can be etched.

In order to solve the above problem, a substrate treating method according to the present invention is a substrate treating method for treating a substrate including, on a surface, a metal film formed region where a metal film is formed and a metal film non-formed region where the metal film is not formed, the substrate treating method comprising: a dissolved oxygen concentration reduction step of reducing a dissolved oxygen concentration of a treating liquid containing a material for forming a self-assembled monolayer; and a self-assembled monolayer forming step of forming the self-assembled monolayer on the metal film in the metal film formed region while suppressing oxidation of the metal film by bringing the treating liquid after the dissolved oxygen concentration reduction step at least into contact with the surface of the substrate.

With the above configuration, as the treating liquid for forming the self-assembled monolayer on the metal film, a treating liquid having a dissolved oxygen concentration that is reduced in advance is used. Thus, it is possible to reduce dissolution of the metal constituting the metal film in the treating liquid as a result of oxidation of the metal film when the dissolved oxygen in the treating liquid comes into contact with the metal film. As a result, the self-assembled monolayer can be formed on the metal film while suppressing or reducing etching of the metal film.

According to the above configuration, the dissolved oxygen concentration reduction step can reduce the dissolved oxygen concentration of the treating liquid by bubbling an inert gas in the treating liquid. With such a method for reducing the dissolved oxygen concentration of the treating liquid, for example, the degree of reduction in the dissolved oxygen concentration in the treating liquid can be easily controlled by adjusting the supply amount and the supply time of the inert gas.

According to the above configuration, the dissolved oxygen concentration reduction step is preferably performed under an inert gas atmosphere. This makes it possible to reduce the dissolved oxygen concentration in the treating liquid while suppressing an increase in the dissolved oxygen concentration due to contact of the treating liquid with oxygen in the air.

According to the above configuration, the self-assembled monolayer forming step is preferably performed under an atmosphere in which the dissolved oxygen concentration of the treating liquid after the dissolved oxygen concentration is reduced is maintained or reduced. This makes it possible to form the self-assembled monolayer on the metal film while suppressing an increase in the dissolved oxygen concentration due to contact of the treating liquid being in contact with the metal film with oxygen in the air. As a result, etching of the metal film can be further prevented at the time of forming the self-assembled monolayer.

According to the above configuration, the dissolved oxygen concentration of the treating liquid after the dissolved oxygen concentration reduction step is preferably less than 100 ppb. This makes it possible to further suppress etching of the metal film when the self-assembled monolayer is formed.

According to the above configuration, as the treating liquid, a treating liquid that contains a phosphonic acid compound having a phosphonic acid group capable of adsorbing a surface of the metal film, and a solvent can be used.

The above configuration can further comprise: a film forming step of selectively forming a film in the metal film non-formed region using the self-assembled monolayer formed in the metal film formed region as a protective film after the self-assembled monolayer forming step; and a removal step of exposing the metal film by removing the self-assembled monolayer formed in the metal film formed region after the film forming step.

With the above configuration, in the film forming step, by using the self-assembled monolayer formed in the metal film formed region as a protective film for the metal film, a film can be selectively formed only in the metal film non-formed region, and formation of a film on the metal film can be inhibited. Further, by removing the self-assembled monolayer in the removal step, a substrate having a stack structure in which the metal film and the film are exposed on the surface can be prepared.

In order to solve the above problem, a substrate treating apparatus of the present invention is a substrate treating apparatus for treating a substrate including, on a surface, a metal film formed region where a metal film is formed and a metal film non-formed region where the metal film is not formed, the substrate treating apparatus comprising: a storage portion that stores a treating liquid containing a material for forming a self-assembled monolayer; a first inert gas supply portion that supplies an inert gas into the treating liquid stored in the storage portion, and reduces a dissolved oxygen concentration of the treating liquid; and a supply portion that supplies the treating liquid after the dissolved oxygen concentration is reduced to the surface of the substrate, and forms the self-assembled monolayer on the metal film in the metal film formed region while suppressing oxidation of the metal film.

With the above configuration, the treating liquid containing the material for forming the self-assembled monolayer is stored in the storage portion, and the first inert gas supply portion supplies the inert gas into the treating liquid, so that the dissolved oxygen concentration in the treating liquid is reduced in advance. Then, when the self-assembled monolayer is formed on the metal film in the metal film formed region of the substrate, the supply portion supplies the treating liquid in which the dissolved oxygen concentration is reduced in advance to the surface of the substrate. Thus, it is possible to reduce dissolution of the metal constituting the metal film in the treating liquid as a result of oxidation of the metal film when the dissolved oxygen in the treating liquid comes into contact with the metal film. As a result, it is possible to provide a substrate treating apparatus capable of forming the self-assembled monolayer while suppressing or reducing etching of the metal film.

In addition, in order to solve the above problem, a substrate treating apparatus of the present invention is a substrate treating apparatus for collectively treating a plurality of substrates each including, on a surface, a metal film formed region where a metal film is formed and a metal film non-formed region where the metal film is not formed, the substrate treating apparatus comprising: a storage portion that stores a treating liquid containing a material for forming a self-assembled monolayer; a first inert gas supply portion that supplies an inert gas into the treating liquid stored in the storage portion, and reduces a dissolved oxygen concentration of the treating liquid; a liquid feed portion that feeds the treating liquid after the dissolved oxygen concentration is reduced from the storage portion toward a downstream side; and a treatment tank that stores the treating liquid after the dissolved oxygen concentration is reduced sent by the liquid feed portion, collectively immerses the plurality of substrates in the treating liquid, and forms the self-assembled monolayer on the metal film in the metal film formed region on the surface of each substrate while suppressing oxidation of the metal film.

With the above configuration, the treating liquid containing the material for forming the self-assembled monolayer is stored in the storage portion, and the first inert gas supply portion supplies the inert gas into the treating liquid, so that the dissolved oxygen concentration in the treating liquid is reduced in advance. Then, when the self-assembled monolayer is formed on the metal film in the metal film formed region of the substrate, the treatment tank stores the treating liquid in which the dissolved oxygen concentration is reduced in advance, and the plurality of substrates is collectively immersed in the treating liquid. Thus, it is possible to reduce dissolution of the metal constituting the metal film in the treating liquid as a result of oxidation of the metal film when the dissolved oxygen in the treating liquid comes into contact with the metal film. As a result, it is possible to provide a substrate treating apparatus capable of forming the self-assembled monolayer while suppressing or reducing etching of the metal film.

According to the above configuration, it is preferable that the first inert gas supply portion brings the inside of the storage portion into an inert gas atmosphere by supplying the inert gas into the storage portion, and reduces the dissolved oxygen concentration of the treating liquid by supplying the inert gas into the treating liquid stored in the storage portion.

With the above configuration, the first inert gas supply portion brings the inside of the storage portion into the inert gas atmosphere, so that the dissolved oxygen concentration in the treating liquid can be reduced while suppressing an increase in the dissolved oxygen concentration due to contact of the treating liquid with oxygen in the air.

According to the above configuration, the supply portion may further comprise an opposing member that closely faces the surface of the substrate at an arbitrary separation distance; and a second inert gas supply portion that supplies the inert gas toward a space between the surface of the substrate and the opposing member, the second inert gas supply portion may supply the inert gas toward the space to bring the space into an atmosphere in which the dissolved oxygen concentration of the treating liquid after the dissolved oxygen concentration is reduced is maintained or reduced, and the supply portion may supply the treating liquid after the dissolved oxygen concentration is reduced to the surface of the substrate under an atmosphere in which the dissolved oxygen concentration of the treating liquid is maintained or reduced.

With the above configuration, the supply portion includes the opposing member that can closely face the surface of the substrate at an arbitrary separation distance, and a space can be formed between the surface of the substrate and the opposing member. In addition, the supply portion includes the second inert gas supply portion capable of supplying an inert gas toward the space, and the air can be replaced with the inert gas in the space. Thus, when the supply portion supplies the treating liquid to the surface of the substrate to form the self-assembled monolayer on the metal film, the treatment can be performed under an atmosphere in which the dissolved oxygen concentration of the treating liquid is maintained or reduced, and the self-assembled monolayer can be formed while suppressing an increase in the dissolved oxygen concentration due to contact of the treating liquid with oxygen in the air. As a result, it is possible to provide a substrate treating apparatus capable of further preventing etching of the metal film at the time of forming the self-assembled monolayer.

In addition, the above configuration may further comprise: a chamber for supplying the treating liquid to the surface of the substrate by the supply portion in a sealed space; a third inert gas supply portion that supplies the inert gas into the chamber; and a depressurization portion that exhausts gas in the chamber, in which the third inert gas supply portion supplies the inert gas into the chamber, and the depressurization portion exhausts the gas in the chamber, so that an inside of the chamber is brought into an atmosphere in which the dissolved oxygen concentration of the treating liquid after the dissolved oxygen concentration is reduced is maintained or reduced, and the supply portion supplies the treating liquid after the dissolved oxygen concentration is reduced to the surface of the substrate under an atmosphere in which the dissolved oxygen concentration of the treating liquid is maintained or reduced.

With the above configuration, by including the chamber, the supply portion can supply the treating liquid to the surface of the substrate in the sealed space. In addition, by including the third inert gas supply portion that supplies the inert gas into the chamber and the depressurization portion that exhausts the gas in the chamber, the air can be replaced with the inert gas in the chamber. Thus, when the supply portion supplies the treating liquid to the surface of the substrate to form the self-assembled monolayer on the metal film, the treatment can be performed under an atmosphere in which the dissolved oxygen concentration of the treating liquid is maintained or reduced, and the self-assembled monolayer can be formed while suppressing an increase in the dissolved oxygen concentration due to contact of the treating liquid with oxygen in the air. As a result, it is possible to provide a substrate treating apparatus capable of further preventing etching of the metal film at the time of forming the self-assembled monolayer.

Further, the above configuration preferably further comprises: a control unit that controls the first inert gas supply portion so that the dissolved oxygen concentration of the treating liquid after the dissolved oxygen concentration is reduced is less than 100 ppb. This makes it possible to further suppress etching of the metal film when the self-assembled monolayer is formed.

### EFFECTS OF THE INVENTION

According to the present invention, it is possible to provide a substrate treating method and a substrate treating apparatus capable of selectively forming a self-assembled monolayer as a protective film while suppressing etching of a metal film on a substrate.

### BRIEF DESCRIPTION OF THE DRAWINGS

Fig. 1 is a flowchart illustrating an example of an overall flow of a substrate treating method according to an embodiment of the present invention.

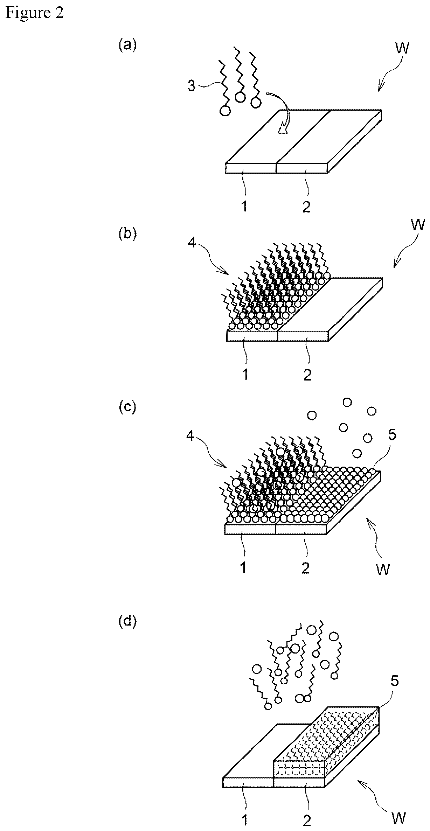

Fig. 2 is a schematic diagram illustrating an example of a state change of a substrate in a film forming method according to the embodiment of the present invention, in which Fig. 2(a) illustrates a state in which a forming material of a self-assembled monolayer is supplied to a substrate surface, Fig. 2(b) illustrates a state in which a self-assembled monolayer is formed in a metal film formed region of the substrate surface, Fig. 2(c) illustrates a state in which a film is formed in a metal film non-formed region of the substrate surface, and Fig. 2(d) illustrates a state in which a self-assembled monolayer in the metal film formed region of the substrate surface is removed.
Fig. 3 is an explanatory diagram schematically illustrating a main part of the substrate treating apparatus according to the embodiment of the present invention.
Fig. 4 is an explanatory diagram schematically illustrating a single wafer type film forming apparatus provided in the substrate treating apparatus according to the embodiment of the present invention.
Fig. 5 is an explanatory diagram schematically illustrating another single wafer type film forming apparatus provided in the substrate treating apparatus according to the embodiment of the present invention.
Fig. 6 is an explanatory diagram schematically illustrating a batch type film forming apparatus provided in the substrate treating apparatus according to the embodiment of the present invention.
Fig. 7 is a graph illustrating a relationship between the dissolved oxygen concentration of treating liquid and the bubbling time according to Example 1 of the present invention.
Fig. 8 is an electron micrograph illustrating a surface state of a substrate sample according to Example 1 of the present invention.

### EMBODIMENTS OF THE INVENTION

### (Substrate Treating method)

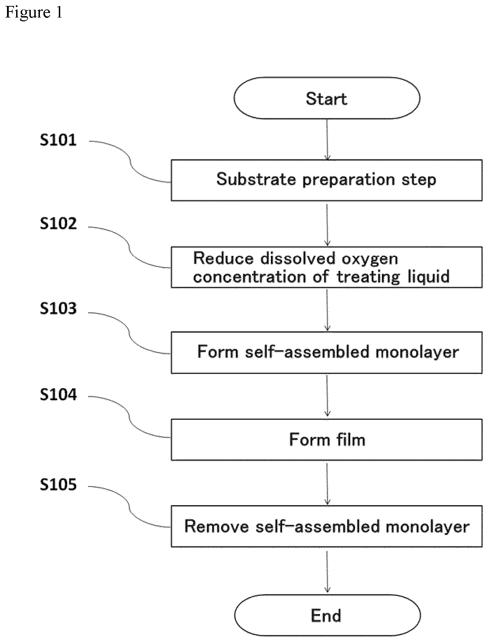

First, a substrate treating method according to the present embodiment will be described below with reference to Figs. 1 and 2. Fig. 1 is a flowchart illustrating an example of an overall flow of a substrate treating method according to the embodiment of the present invention. Figs. 2(a) to 2(d) are schematic diagrams illustrating an example of a state change of a substrate in a film forming method according to the embodiment of the present invention, in which Fig. 2(a) illustrates a state in which a forming material of a self-assembled monolayer is supplied to a substrate surface, Fig. 2(b) illustrates a state in which a self-assembled monolayer is formed in a metal film formed region of the substrate surface, Fig. 2(c) illustrates a state in which a film is formed in a metal film non-formed region of the substrate surface, and Fig. 2(d) illustrates a state in which a self-assembled monolayer in the metal film formed region of the substrate surface is removed.

The substrate treating method of the present embodiment provides a technique for selectively forming a film according to the material of the substrate surface when a film is formed on the surface of a substrate W. Note that, in the present specification, the "substrate" refers to various substrates such as a semiconductor substrate, a glass substrate for a photomask, a glass substrate for a liquid crystal display, a glass substrate for a plasma display, a substrate for a field emission display (FED), a substrate for an optical disk, a substrate for a magnetic disk, and a substrate for a magneto-optical disk.

As illustrated in Fig. 1, the substrate treating method of the present embodiment includes at least a preparation step S 101 for the substrate W, a dissolved oxygen concentration reduction step S 102 for the treating liquid, a self-assembled monolayer (hereinafter, referred to as "SAM") forming step S103, a film forming step S104, and a removal step S105 for removing the SAM.

As illustrated in Figs. 1 and 2(a), the substrate W prepared in the preparation step S 101 for the substrate W includes a metal film formed region formed by exposing a metal film 1 and a metal film non-formed region formed by exposing an insulating film 2. More specifically, examples of the substrate W include a substrate including the insulating film 2 in which a trench having an arbitrary wiring width is formed and the metal film 1 embedded in the trench. Note that the preparation step for the substrate W can include, for example, loading the substrate W into a chamber (details will be described below) that is a container for accommodating the substrate W by a substrate loading/unloading mechanism.

Although one metal film formed region and one metal film non-formed region are formed in Fig. 2(a), a plurality of metal film formed regions and a plurality of metal film non-formed regions may be formed. For example, a strip-shaped metal film non-formed region may be disposed so as to be interposed between adjacent strip-shaped metal film formed regions, or a strip-shaped metal film formed region may be disposed so as to be interposed between adjacent strip-shaped metal film non-formed regions.

In addition, the substrate W of the present embodiment is not limited to the case where only the metal film formed region and the metal film non-formed region are provided on the surface thereof. For example, another film made of a material different from that of the metal film 1 and the insulating film 2 may be provided in a region formed to be exposed on the surface. In this case, the position where the region is provided is not particularly limited, but can be arbitrarily set.

The metal film 1 is not particularly limited, and examples thereof include those made of copper (Cu), tungsten (W), ruthenium (Ru), germanium (Ge), silicon (Si), titanium nitride (TiN), cobalt (Co), molybdenum (Mo), and the like.

In addition, the insulating film 2 is not particularly limited, and examples thereof include those made of silicon oxide (SiO₂), hafnium oxide (HfO₂), zirconia (ZrO₂), silicon nitride (SiN), and the like.

The dissolved oxygen concentration reduction step S102 for the treating liquid is a step of reducing the dissolved oxygen concentration in the treating liquid containing a SAM forming material. Thus, it is possible to reduce that the metal film is oxidized, the metal is dissolved in the treating liquid, and the metal film is etched.

The method for reducing the dissolved oxygen concentration of the treating liquid is not particularly limited, and examples thereof include a method in which an inert gas is supplied into the treating liquid to perform bubbling, and a method using a vacuum deaeration apparatus or an oxygen permeable membrane. Examples of the inert gas include nitrogen (N₂) gas, helium (He) gas, neon (Ne) gas, and argon (Ar) gas.

When the dissolved oxygen concentration in the treating liquid is reduced by bubbling using an inert gas, this step is preferably performed under an inert gas atmosphere. Thus, the dissolved oxygen concentration in the treating liquid can be further reduced. In addition, in the case of performing under an inert gas atmosphere, the oxygen concentration in the inert gas atmosphere is preferably less than 0.1%, more preferably 100 ppm or less, and particularly preferably 10 ppm or less. When the dissolved oxygen concentration of the treating liquid is reduced under an inert gas atmosphere having an oxygen concentration of less than 0.1%, the oxygen contained under the atmosphere can be prevented from being dissolved in the treating liquid, and the dissolved oxygen concentration in the treating liquid can be further reduced. Note that, as the inert gas, nitrogen (N₂) gas, helium (He) gas, neon (Ne) gas, argon (Ar) gas, and the like can be used.

The dissolved oxygen concentration of the treating liquid after the dissolved oxygen concentration reduction step (or immediately before bringing the treating liquid into contact with the substrate W) is preferably less than 100 ppb, more preferably 50 ppb or less, and particularly preferably 10 ppb or less.

The treating liquid contains at least a material forming the SAM (hereinafter, referred to as the "SAM forming material") and a solvent. The SAM forming material may be dissolved or dispersed in a solvent.

The SAM forming material is not particularly limited, and examples thereof include phosphonic acid compounds having a phosphonic acid group such as monophosphonic acid and diphosphonic acid. These phosphonic acid compounds can be used alone or as a mixture of two or more types.

The monophosphonic acid is not particularly limited, and examples thereof include phosphonic acid compounds represented by the general formula R-P(=O)(OH)₂ (where R is an alkyl group represented by 1 to 18 carbon atoms; an alkyl group in the range of 1 to 18 carbon atoms and having a fluorine atom; or a vinyl group). Note that, in the present specification, when the range of the number of carbon atoms is represented, it means that the range includes the number of carbon atoms of all integers included in the range. Therefore, for example, an alkyl group having "1 to 3 carbon atoms" means all alkyl groups having 1, 2, and 3 carbon atoms.

The alkyl group represented by 1 to 18 carbon atoms may be either linear or branched. Further, the number of carbon atoms of the alkyl group is preferably in the range of 10 to 18, and more preferably in the range of 14 to 18. In addition, the alkyl group in the range of 1 to 18 carbon atoms and having a fluorine atom may be either linear or branched. Further, the number of carbon atoms of the alkyl group having a fluorine atom is preferably in the range of 10 to 18, and more preferably in the range of 14 to 18.

Further, specific examples of the monophosphonic acid represented by R-P(=O)(OH)₂ include compounds represented by any of Chemical Formulae (1) to (16) described below.

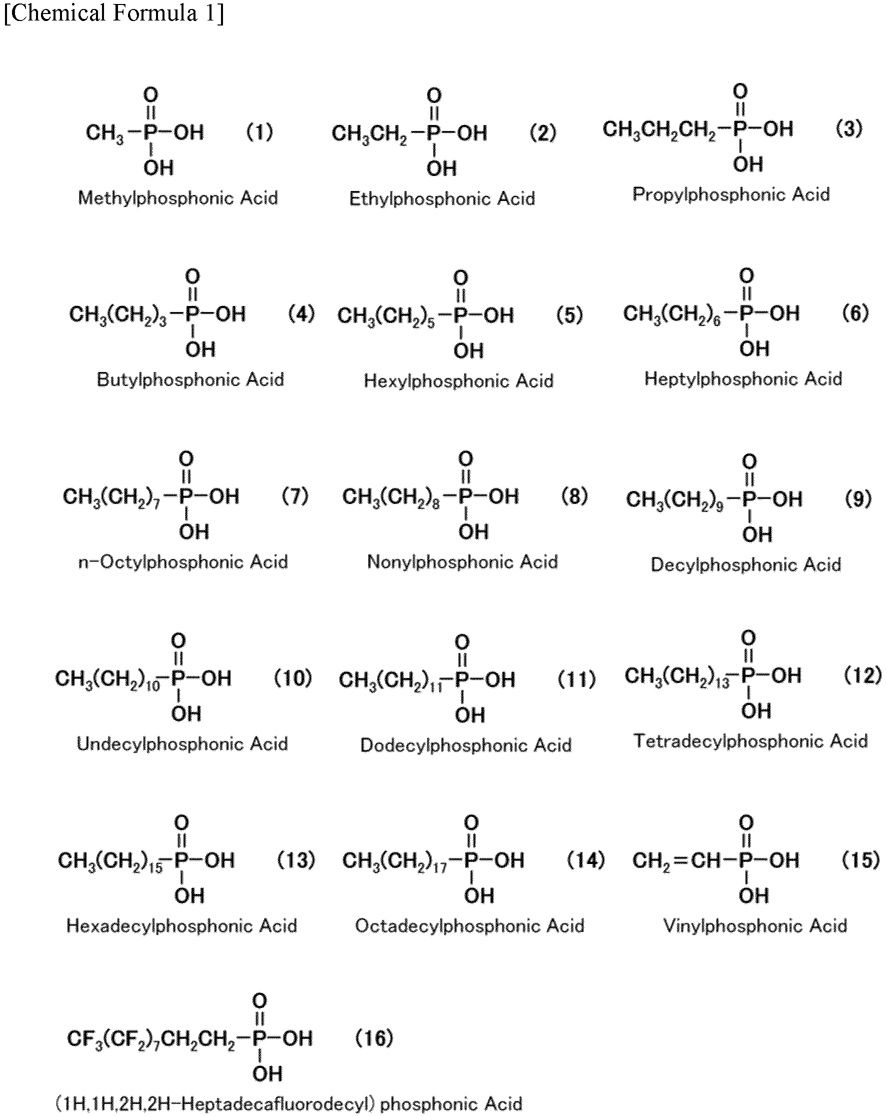

In addition, as the monophosphonic acid, in addition to those exemplified above, a compound represented by any of Chemical Formulae (17) to (19) described below can also be used.

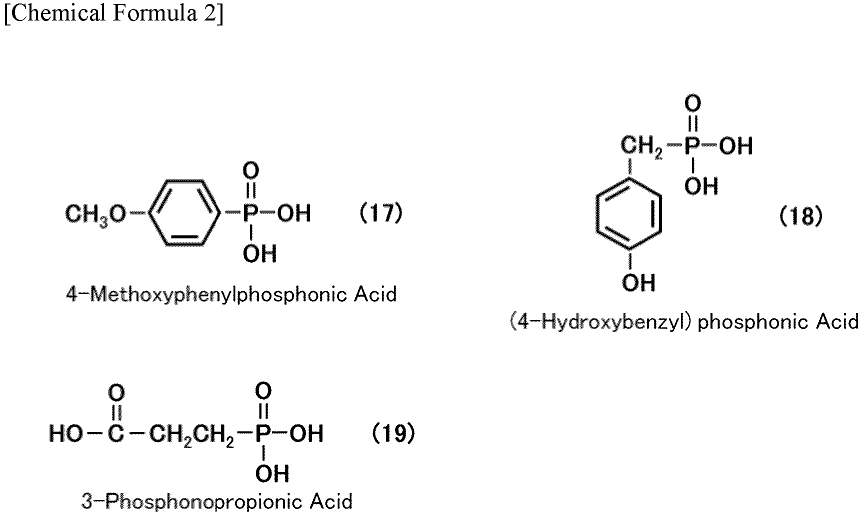

Examples of the diphosphonic acid include a compound represented by any of Chemical Formulae (20) and (21) described below.

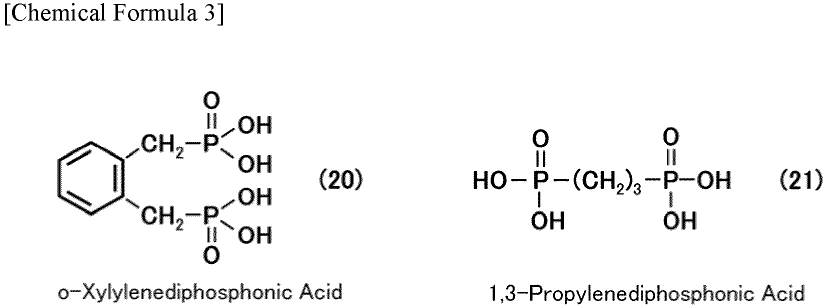

Among the exemplified phosphonic acid compounds, octadecylphosphonic acid or the like is preferable from the viewpoint of formation of a dense SAM.

The solvent in the treating liquid is not particularly limited, and examples thereof include an alcohol solvent, an ether solvent, a glycol ether solvent, and a glycol ester solvent. The alcohol solvent is not particularly limited, and examples thereof include ethanol. The ether solvent is not particularly limited, and examples thereof include tetrahydrofuran (THF). The glycol ether solvent is not particularly limited, and examples thereof include propylene glycol monomethyl ether (PGME). The glycol ester solvent is not particularly limited, and examples thereof include propylene glycol monomethyl ether acetate (PGMEA). These solvents can be used alone or as a mixture of two or more types. In addition, these solvents can be used in any combination with the above-described exemplified phosphonic acid compounds. Among the exemplified solvents, an alcohol solvent is preferable, and ethanol is particularly preferable from the viewpoint that the phosphonic acid compound can be dissolved.

The content of the SAM forming material is preferably in a range of 0.0004 mass% to 0.2 mass%, more preferably in a range of 0.004 mass% to 0.08 mass%, and particularly preferably in a range of 0.02 mass% to 0.06 mass% with respect to the total mass of the treating liquid.

In addition, the treating liquid may contain a known additive as long as the effect of the present invention is not impaired. The additive is not particularly limited, and examples thereof include a stabilizer and a surfactant.

As illustrated in Figs. 1, 2(a), and 2(b), the SAM forming step S103 is a step of forming a SAM 4 by bringing the treating liquid after the dissolved oxygen concentration is reduced into contact with the surface of the substrate W and adsorbing a SAM forming material 3 contained in the treating liquid on the surface of the metal film 1. Here, the SAM 4 is selectively formed only on the metal film 1 in the metal film formed region of the substrate W, and is not formed in the metal film non-formed region. The reason why the SAM 4 is formed only on the metal film 1 is that, for example, when the metal film 1 is a Cu (copper) film, the phosphonic acid group of the phosphonic acid compound as the SAM forming material 3 and the -OH group on the surface of the Cu film react with each other as expressed by the chemical reaction formula described below.

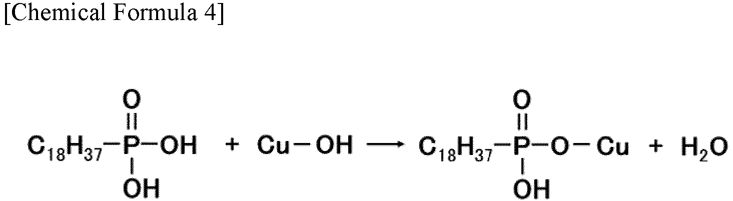

Here, H₂O is generated when the phosphonic acid compound is adsorbed on the surface of the Cu film, but in the present invention, the dissolved oxygen concentration in the treating liquid to be brought into contact with the substrate W is reduced in advance, so that the dissolution of Cu in H₂O is reduced as much as possible. Therefore, the present embodiment can suppress etching of the Cu film as compared with a case where the SAM is formed without reducing the dissolved oxygen concentration of the treating liquid.

The method of bringing the treating liquid into contact with the substrate W is not particularly limited, and examples thereof include a method of applying the treating liquid to the surface of the substrate W, a method of spraying the treating liquid to the surface of the substrate W, and a method of immersing the substrate W in the treating liquid.

Examples of the method of applying the treating liquid to the surface of the substrate W include a method of supplying the treating liquid to the central portion of the surface of the substrate W in a state where the substrate W is rotated at a constant speed about the central portion thereof as the axis. Thus, the treating liquid supplied to the surface of the substrate W flows from the vicinity of the center of the surface of the substrate W toward the peripheral edge portion of the substrate W by a centrifugal force generated as a result of the rotation of the substrate W, and diffuses to the entire surface of the surface of the substrate W. As a result, the entire surface of the surface of the substrate W is covered with the treating liquid, and a liquid film of the treating liquid is formed.

The SAM forming step S 103 is preferably performed under an atmosphere in which the dissolved oxygen concentration of the treating liquid after the dissolved oxygen concentration is reduced is maintained or reduced. This makes it possible to prevent oxygen contained in the atmosphere from being dissolved in the treating liquid during formation of the SAM 4. As a result, a state in which the dissolved oxygen concentration of the treating liquid is reduced can be favorably maintained. In the case of performing this step under an inert gas atmosphere, the oxygen concentration in the inert gas atmosphere is preferably less than 0.1%, more preferably 100 ppm or less, and particularly preferably 10 ppm or less.

The SAM forming step S103 can include a step of removing the treating liquid remaining on the surface of the substrate W. The step of removing the treating liquid is not particularly limited, and examples thereof include a step of shaking off the treating liquid using a centrifugal force by rotating the substrate W at a constant speed.

In addition, when the step of shaking off the treating liquid using a centrifugal force is performed, the rotation rate of the substrate W is not particularly limited as long as the treating liquid can be sufficiently shaken off, but is usually set in the range of 800 rpm to 2500 rpm, preferably 1000 rpm to 2000 rpm, and more preferably 1200 rpm to 1500 rpm.

As illustrated in Figs. 1 and 2(c), the film forming step S 104 is a step of forming a target film 5 on the insulating film 2 in the metal film non-formed region. At this time, the SAM 4 formed in the metal film formed region functions to mask the metal film 1 as a protective film. Thus, the target film 5 can be selectively formed in the metal film non-formed region.

The target film 5 is not particularly limited, and examples thereof include a film made of aluminum oxide (Al₂O₃), cobalt oxide (CoO), zirconium oxide (ZrO₂), or the like. In addition, the method for forming these films 5 is not particularly limited, and examples thereof include a chemical vapor deposition (CVD) method, an atomic layer deposition (ALD) method, vacuum deposition, sputtering, plating, thermal CVD, thermal ALD, and the like.

As illustrated in Figs. 1 and 2(d), the removal step S 105 is a step of removing the SAM 4 formed in the metal film formed region after the step of forming the film 5 is executed. The method of removing the SAM 4 is not particularly limited, and for example, a method of directly removing the SAM 4 by dissolution, etching, or the like, a method of thinly peeling the surface layer portion of the metal film 1 together with the SAM 4, or the like can be used.

For example, in the case of removing the SAM 4 composed of a phosphonic acid compound, the SAM 4 can be oxidized by irradiating the SAM 4 with ultraviolet rays, and then the SAM 4 can be removed by bringing acetic acid into contact with the SAM 4. Thus, as illustrated in Fig. 2(d), it is possible to obtain the substrate W in which the film 5 is selectively formed only in the metal film non-formed region and the metal film 1 is exposed. Note that ultraviolet ray emission conditions are not particularly limited, and can be appropriately set as necessary.

In addition, when the SAM 4 is removed by etching, for example, the SAM 4 can be removed by bringing an oxygen-containing gas into contact and gasifying the SAM 4. Note that the oxygen-containing gas is not particularly limited, and examples thereof include oxygen (O₂) gas and ozone (O₃) gas. These oxygen-containing gases may be heated to a high temperature to promote a chemical reaction. In addition, these oxygen-containing gases may be turned into plasma to promote a chemical reaction.

As described above, by the substrate treating method of the present embodiment, by forming the SAM 4 using the treating liquid in which the dissolved oxygen concentration is reduced, it is possible to suppress etching of the metal film 1 in the process of selective film formation of the SAM 4 in the metal film formed region.

### (Substrate Treating apparatus)

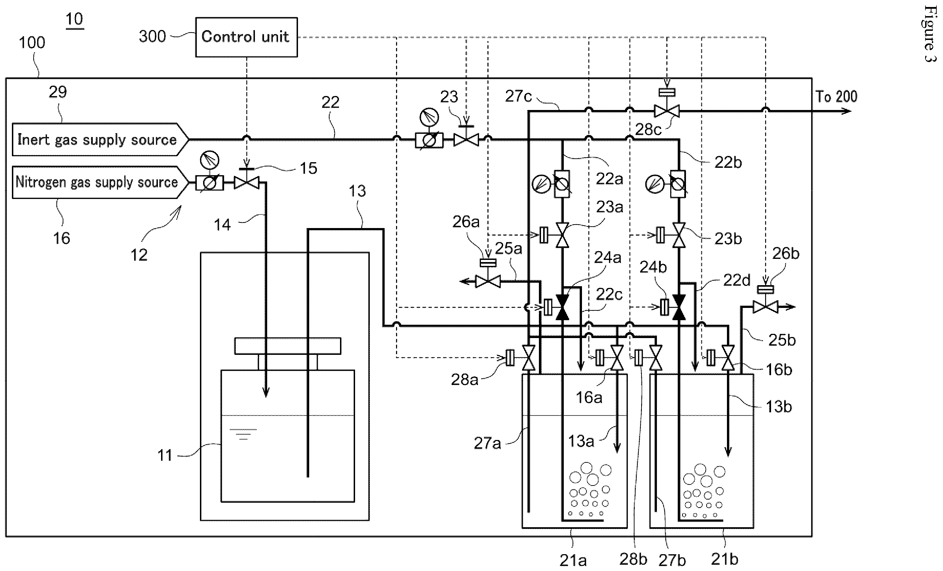

Next, the substrate treating apparatus according to the present embodiment will be described with reference to Fig. 3. Fig. 3 is an explanatory diagram illustrating a main part of the substrate treating apparatus according to the present embodiment.

As illustrated in Fig. 3, a substrate treating apparatus 10 of the present embodiment includes at least a treating liquid supply apparatus 100 for supplying the treating liquid, a film forming apparatus 200 for forming the SAM 4, and a control unit 300 for controlling each portion of the substrate treating apparatus 10.

### [Treating liquid Supply Apparatus]

As illustrated in Fig. 3, the treating liquid supply apparatus 100 according to the present embodiment has a function of supplying the treating liquid having a dissolved oxygen concentration reduced as compared with the beginning to the film forming apparatus 200, and includes a treating liquid tank 11, a pressurization portion 12, and a pipe 13.

The treating liquid tank 11 may include a stirring portion that stirs the treating liquid in the treating liquid tank 11 and a temperature adjustment portion that adjusts the temperature of the treating liquid in the treating liquid tank 11 (neither is illustrated). Examples of the stirring portion include a rotation portion that stirs the treating liquid in the treating liquid tank 11 and a stirring control unit that controls rotation of the rotation portion. The stirring control unit is electrically connected to the control unit 300, and the rotation portion includes, for example, a propeller-like stirring blade at the lower end of the rotation shaft. The control unit 300 gives an operation command to the stirring control unit to rotate the rotation portion, whereby the treating liquid can be stirred by the stirring blade. As a result, the concentration and temperature of the treating liquid can be made uniform in the treating liquid tank 11.

The pressurization portion 12 includes a nitrogen gas supply source 16 as a supply source of gas for pressurizing the inside of the treating liquid tank 11, a pump (not illustrated) for pressurizing nitrogen gas, a nitrogen gas supply pipe 14, and a valve 15 provided in the middle of the path of the nitrogen gas supply pipe 14. The nitrogen gas supply source 16 is line-connected to the treating liquid tank 11 via the nitrogen gas supply pipe 14. An atmospheric pressure sensor (not illustrated) electrically connected to the control unit 300 can be provided in the treating liquid tank 11. In this case, the control unit 300 can maintain the pressure in the treating liquid tank 11 at a predetermined pressure higher than the atmospheric pressure by controlling the operation of the pump based on the value detected by the atmospheric pressure sensor. In addition, by also electrically connecting the valve 15 to the control unit 300, opening and closing of the valve 15 can be controlled according to an operation command of the control unit 300. When the valve 15 is opened according to an operation command of the control unit 300, the treating liquid is pumped through the pipe 13.

The pipe 13 is branched into a first pipe 13a and a second pipe 13b, the first pipe 13a is line-connected to a first storage portion 21a, and the second pipe 13b is line-connected to a second storage portion 21b (details of the first storage portion 21a and the second storage portion 21b will be described below). Further, a first valve 16a is provided in the middle path of the first pipe 13a, and a second valve 16b is provided in the middle path of the second pipe 13b. The first valve 16a and the second valve 16b are electrically connected to the control unit 300, and opening and closing of the first valve 16a and the second valve 16b can be controlled according to an operation command of the control unit 300. When the first valve 16a and the second valve 16b are opened according to an operation command of the control unit 300, the treating liquid can be supplied to each of the first storage portion 21a and the second storage portion 21b.

In addition, the treating liquid supply apparatus 100 includes the first storage portion 21a and the second storage portion 21b as storage portions for storing the treating liquid, and a first inert gas supply portion for supplying an inert gas to each of the first storage portion 21a and the second storage portion 21b.

In the first storage portion 21a and the second storage portion 21b, the treating liquid supplied from the treating liquid tank 11 is subjected to the treatment of reducing the dissolved oxygen concentration by the inert gas supplied from the first inert gas supply portion. Each of the first storage portion 21a and the second storage portion 21b may include a stirring portion that stirs the stored treating liquid and a temperature adjustment portion that adjusts the temperature of the treating liquid (neither is illustrated). As the stirring portion, the same stirring portion as that installable in the treating liquid tank 11 can be used.

The first inert gas supply portion includes an inert gas supply source 29, a pump (not illustrated) for pressurizing the inert gas, an inert gas supply pipe 22, and a valve 23 provided in the middle path of the inert gas supply pipe 22. The inert gas supply pipe 22 is branched into a first inert gas supply pipe 22a and a second inert gas supply pipe 22b on the downstream side of the valve 23. By electrically connecting the valve 23 to the control unit 300, opening and closing of the valve 23 can be controlled according to an operation command of the control unit 300. When the valve 23 is opened according to an operation command of the control unit 300, the inert gas can be supplied to the first storage portion 21a and the second storage portion 21b.

In the middle path of the first inert gas supply pipe 22a, a first upstream valve 23a and a first downstream valve 24a are sequentially provided from the upstream side to the downstream side. In addition, also in the middle path of the second inert gas supply pipe 22b, a second upstream valve 23b and a second downstream valve 24b are sequentially provided from the upstream side to the downstream side. Further, a bubbling nozzle for discharging an inert gas is provided at each of the ends of the first inert gas supply pipe 22a and the second inert gas supply pipe 22b. The bubbling nozzles are preferably provided so as to be located in the vicinity of the bottom portions of the first storage portion 21a and the second storage portion 21b so as to be below the liquid level of the stored treating liquid. In addition, the bubbling nozzle is preferably provided with a plurality of discharge ports for discharging the inert gas. Further, it is preferable that the bubbling nozzles extend in a substantially horizontal direction with respect to the bottom portions of the first storage portion 21a and the second storage portion 21b.

The supply amount and the supply time of the inert gas to the first storage portion 21a and the second storage portion 21b can be controlled by adjusting the opening degree of the first upstream valve 23a and/or the first downstream valve 24a in the first inert gas supply pipe 22a, and by adjusting the opening degree of the second upstream valve 23b and/or the second downstream valve 24b in the second inert gas supply pipe 22b. Then, the opening degrees of the first upstream valve 23a, the first downstream valve 24a, the second upstream valve 23b, and the second downstream valve 24b can be adjusted according to an operation command of the control unit 300.

Note that the degree of reduction in dissolved oxygen concentration in the treating liquid in the first storage portion 21a and the second storage portion 21b can be adjusted by controlling the supply amount and the supply time of the inert gas. In addition, the supply amounts and the supply times of the inert gas supplied to the first storage portion 21a and the second storage portion 21b are made different between the first inert gas supply pipe 22a and the second inert gas supply pipe 22b, whereby the dissolved oxygen concentration of the treating liquid stored in the first storage portion 21a and the dissolved oxygen concentration of the treating liquid stored in the second storage portion 21b can be made different from each other.

In addition, in the first inert gas supply pipe 22a, a first branch pipe 22c is line-connected so as to branch between the first upstream valve 23a and the first downstream valve 24a. Also in the second inert gas supply pipe 22b, a second branch pipe 22d is line-connected so as to branch between the second upstream valve 23b and the second downstream valve 24b. Further, a first discharge pipe 25a and a second discharge pipe 25b for depressurizing the inside are line-connected to the first storage portion 21a and the second storage portion 21b, respectively. The first discharge pipe 25a and the second discharge pipe 25b are respectively provided with a first exhaust valve 26a and a second exhaust valve 26b in the middle paths. In addition, each of the first discharge pipe 25a and the second discharge pipe 25b may be connected to an exhaust pump (not illustrated). With these configurations, the treatment for reducing the dissolved oxygen concentration in the first storage portion 21a and the second storage portion 21b can be performed under the inert gas atmosphere. That is, for example, in the case of the first storage portion 21a, the valve 23, the first upstream valve 23a, and the first exhaust valve 26a are opened, and the first downstream valve 24a is closed according to an operation command of the control unit 300. Thus, when the inert gas is supplied into the first storage portion 21a, the air inside the first storage portion 21a is discharged from the first discharge pipe 25a, and the air is replaced with the inert gas. As a result, the inside of the first storage portion 21a can be made into an inert gas atmosphere, and the oxygen concentration inside the first storage portion 21a can be reduced. Note that when air in the first storage portion 21a and the second storage portion 21b is replaced with an inert gas, air may be discharged from the first discharge pipe 25a and the second discharge pipe 25b using an exhaust pump. That is, by opening the first exhaust valve 26a and the second exhaust valve 26b and operating the exhaust pump according to an operation command of the control unit 300 to discharge the air inside the first storage portion 21a and the second storage portion 21b, the replacement with the inert gas can be quickly performed.

Further, a first discharge pipe 27a and a second discharge pipe 27b for supplying the treating liquid after the reduction in dissolved oxygen concentration to the film forming apparatus 200 are line-connected to the first storage portion 21a and the second storage portion 21b, respectively. The first discharge pipe 27a and the second discharge pipe 27b are respectively provided with a first discharge valve 28a and a second discharge valve 28b in the middle paths. Further, the first discharge pipe 27a and the second discharge pipe 27b are line-connected to a third discharge pipe 27c so as to merge on the downstream side of the first discharge valve 28a and the second discharge valve 28b. A third discharge valve 28c is provided in the middle of the path of the third discharge pipe 27c. In addition, an atmospheric pressure sensor electrically connected to the control unit 300 can be provided inside the first storage portion 21a and the second storage portion 21b. In this case, the control unit 300 can maintain the pressure in the first storage portion 21a and the second storage portion 21b at a predetermined pressure higher than the atmospheric pressure by controlling the operation of the pump based on the value detected by the atmospheric pressure sensor. In addition, by also electrically connecting the first discharge valve 28a, the second discharge valve 28b, and the third discharge valve 28c to the control unit 300, opening and closing of the valves can be controlled according to an operation command of the control unit 300. When the first discharge valve 28a, the second discharge valve 28b, and the third discharge valve 28c are opened according to an operation command of the control unit 300, the treating liquid after the reduction in dissolved oxygen concentration is pumped to the film forming apparatus 200 via the first discharge pipe 27a, the second discharge pipe 27b, and the third discharge pipe 27c.

Note that, in the present embodiment, the case where the treating liquid supply apparatus 100 includes a pair of the first storage portion 21a and the second storage portion 21b has been described as an example. However, the present invention is not limited to this aspect, and the number of storage portions may be one, for example.

### [Film Forming Apparatus]

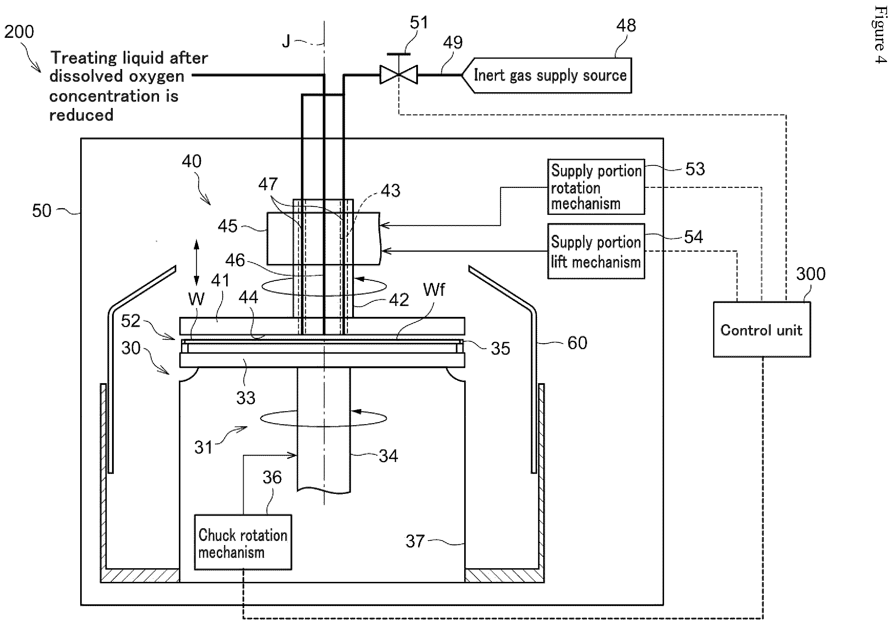

Next, the film forming apparatus 200 will be described with reference to Fig. 4. Fig. 4 is an explanatory diagram schematically illustrating the film forming apparatus 200 provided in the substrate treating apparatus 10.

The film forming apparatus 200 according to the present embodiment is a single wafer type film forming apparatus capable of forming the SAM 4 in the metal film formed region where the metal film 1 is formed.

As illustrated in Fig. 4, the film forming apparatus 200 includes at least a substrate holding portion 30 that holds the substrate W, a supply portion 40 that supplies the treating liquid to a surface Wf of the substrate W, a chamber 50 that is a container that accommodates the substrate W, and a dispersion prevention cup 60 that collects the treating liquid. In addition, the film forming apparatus 200 can also include a loading and unloading means (not illustrated) that loads or unloads the substrate W.

The substrate holding portion 30 is a means that holds the substrate W, and rotates the substrate W while holding the substrate W in a substantially horizontal orientation with the substrate surface Wf facing upward as illustrated in Fig. 4. The substrate holding portion 30 includes a spin chuck 31 in which a spin base 33 and a rotation support shaft 34 are integrally joined. The spin base 33 has a substantially circular shape in plan view, and the hollow rotation support shaft 34 extending in a substantially vertical direction is fixed to a center portion thereof. The rotation support shaft 34 is coupled to a rotation shaft of a chuck rotation mechanism 36 including a motor. The chuck rotation mechanism 36 is accommodated in a casing 37 having a cylindrical shape, and the rotation support shaft 34 is rotatably supported by the casing 37 about the rotation axis in the vertical direction.

The chuck rotation mechanism 36 can rotate the rotation support shaft 34 about the rotation axis by driving from a chuck drive portion (not illustrated) of the control unit 300. Thus, the spin base 33 attached to an upper end portion of the rotation support shaft 34 rotates about a rotation axis J. The control unit 300 can control the chuck rotation mechanism 36 via the chuck drive portion to adjust the rotation speed of the spin base 33.

In the vicinity of the peripheral edge portion of the spin base 33, a plurality of chuck pins 35 for gripping the peripheral end portion of the substrate W is erected. The number of chuck pins 35 to be installed is not particularly limited, but it is preferable to provide at least three or more chuck pins in order to unfailingly hold the substrate W having a circular shape. In the present embodiment, three chuck pins are disposed at equal intervals along the peripheral edge portion of the spin base 33. Each of the chuck pins 35 includes a substrate support pin that supports the peripheral edge portion of the substrate W from below, and a substrate holding pin that presses an outer peripheral end surface of the substrate W supported by the substrate support pin to hold the substrate W.

The supply portion 40 is disposed above the substrate holding portion 30, and supplies the treating liquid supplied from the treating liquid supply apparatus 100 onto the surface Wf of the substrate W. The supply portion 40 includes an opposing member 41 having an annular shape having an opening at a center portion, a second inert gas supply portion, a rotation support shaft 42 having a substantially cylindrical shape that supports the opposing member 41, an insertion shaft 43 inserted into the inside of the rotation support shaft 42 and the opening of the opposing member 41, and an arm 45.

The opposing member 41 is attached substantially horizontally to the lower end portion of the rotation support shaft 42, and is disposed to face the surface Wf of the substrate W held by the substrate holding portion 30. In addition, the lower surface (bottom surface) 44 of the opposing member 41 is a substrate facing surface that faces the surface Wf of the substrate W substantially in parallel. The lower surface 44 of the opposing member 41 is formed to have a size equal to or larger than the diameter of the substrate W. A bearing (not illustrated) is provided between the inner peripheral surface of the rotation support shaft 42 and the outer peripheral surface of the insertion shaft 43, so that the rotation support shaft 42 is rotatable with respect to the insertion shaft 43. In addition, the rotation support shaft 42 is rotatably held about the rotation axis J passing through the center of the substrate W by the arm 45 extending in the horizontal direction.

The second inert gas supply portion includes an inert gas supply source 48, a pump (not illustrated) for pressurizing the inert gas, an inert gas supply pipe 49, and a valve 51 provided in the middle path of the inert gas supply pipe 49. An inert gas supply path 47 is line-connected to the inert gas supply source 48 via the inert gas supply pipe 49. By electrically connecting the valve 51 to the control unit 300, opening and closing of the valve 51 can be controlled according to an operation command of the control unit 300. When the valve 51 is opened according to an operation command of the control unit 300, the inert gas can be supplied toward the surface Wf of the substrate W.

The rotation support shaft 42 internally includes a treating liquid supply path 46 through which the treating liquid flows and the inert gas supply path 47 through which the inert gas flows. The treating liquid supply path 46 is line-connected to the third discharge pipe 27c of the treating liquid supply apparatus 100. In addition, the treating liquid supply path 46 communicates with a discharge port (not illustrated) provided at the distal end portion of the rotation support shaft 42. This enables the treating liquid to be discharged from the distal end portion of the rotation support shaft 42. An inert gas supply path 47 is line-connected to the inert gas supply source 48 via the inert gas supply pipe 49. In addition, the inert gas supply path 47 communicates with another discharge port (not illustrated) provided at the distal end portion of the rotation support shaft 42. This enables the inert gas to be discharged from the distal end portion of the rotation support shaft 42.

The supply portion 40 further includes a supply portion rotation mechanism 53 and a supply portion lift mechanism 54. The supply portion rotation mechanism 53 and the supply portion lift mechanism 54 are connected to the arm 45 of the rotation support shaft 42.

The supply portion rotation mechanism 53 is electrically connected to the control unit 300, and rotates the rotation support shaft 42 according to an operation command from the control unit 300. By this rotation operation, the opposing member 41 rotates integrally with the rotation support shaft 42. The supply portion rotation mechanism 53 can rotate the opposing member 41 in the same rotation direction and at substantially the same rotation speed as the substrate W according to the rotation of the substrate W held by the substrate holding portion 30. When the inert gas is discharged from another discharge port, by rotating the opposing member 41 and the substrate W, the inert gas can be caused to flow from the central portion of the substrate W toward the peripheral edge portion of the substrate W by the centrifugal force generated by the rotation, and can be diffused over the entire surface of the surface Wf of the substrate W.

The supply portion lift mechanism 54 is electrically connected to the control unit 300, and can lift the supply portion 40 according to an operation command from the control unit 300. Thus, the opposing member 41 of the supply portion 40 can approach or move away from the substrate W held by the substrate holding portion 30, and the separation distance between the lower surface 44 of the opposing member 41 and the surface Wf of the substrate W can be adjusted. When the surface Wf of the substrate W is brought into an inert gas atmosphere, the supply portion lift mechanism 54 is operated according to an operation command of the control unit 300 to lower the supply portion 40. Thus, the lower surface 44 of the opposing member 41 is caused to approach the surface Wf of the substrate W to form a minute space 52. Further, when the valve 51 is opened according to an operation command of the control unit 300 and the inert gas is discharged from the discharge port of the rotation support shaft 42 toward the surface Wf of the substrate W, the air in the space 52 between the lower surface 44 of the opposing member 41 and the surface Wf of the substrate W is replaced with the inert gas. Thus, the space 52 can be made into an inert gas atmosphere, and the oxygen concentration in the space 52 can be reduced. As a result, the change in dissolved oxygen concentration of the treating liquid supplied to the surface Wf of the substrate W thereafter can be suppressed, and etching of the metal film 1 by the treating liquid can be further prevented. Note that the formation of the inert gas atmosphere in the space 52 by the supply of the inert gas is preferably performed before the start of the self-assembled monolayer forming step S103. In addition, the supply of the inert gas may be continuously or intermittently performed during the self-assembled monolayer forming step S103.

Note that when the substrate W is loaded into and unloaded from the film forming apparatus 200, the supply portion lift mechanism 54 is operated according to an operation command of the control unit 300 to lift the supply portion 40. Thus, the lower surface 44 of the opposing member 41 and the surface Wf of the substrate W can be separated at a certain distance, and the substrate W can be easily loaded and unloaded.

The dispersion prevention cup 60 is provided so as to surround the spin base 33. The dispersion prevention cup 60 is connected to a lift drive mechanism (not illustrated) and can be lifted in an up-down direction. When the treating liquid is supplied to the surface Wf of the substrate W, the dispersion prevention cup 60 is positioned at a predetermined position by the lift drive mechanism, and surrounds the substrate W held by the chuck pins 35 from a side position. Thus, the treating liquid dispersed from the substrate W or the spin base 33 can be collected.

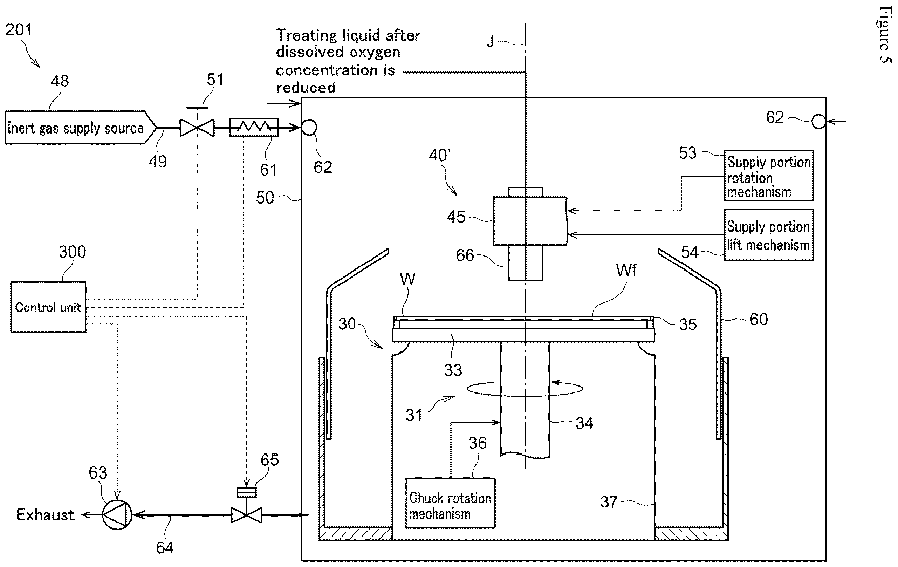

Next, another film forming apparatus 201 will be described with reference to Fig. 5. Fig. 5 is an explanatory diagram schematically illustrating another film forming apparatus provided in the substrate treating apparatus. Note that, in another film forming apparatus illustrated in Fig. 5, those having the same configuration as those of the film forming apparatus 200 described above are denoted by the same reference numerals, and the description thereof is omitted.

As illustrated in Fig. 5, another film forming apparatus 201 includes at least the substrate holding portion 30 that holds the substrate W, a supply portion 40' that supplies the treating liquid to the surface Wf of the substrate W, the chamber 50 that is a container that accommodates the substrate W, a third inert gas supply portion that supplies the inert gas into the chamber 50, a depressurization portion that exhausts the gas in the chamber 50, and the dispersion prevention cup 60 that collects the treating liquid. In addition, the film forming apparatus 201 can also include a loading and unloading means (not illustrated) that loads or unloads the substrate W.

The supply portion 40' is disposed above the substrate holding portion 30, and supplies the treating liquid supplied from the treating liquid supply apparatus 100 onto the surface Wf of the substrate W. The supply portion 40' includes a nozzle 66 and the arm 45. The nozzle 66 is attached to the distal end portion of the arm 45 that is horizontally extended, and is disposed above the spin base 33 when the treating liquid is discharged.

The third inert gas supply portion includes the inert gas supply source 48, the pump (not illustrated) for pressurizing the inert gas, the inert gas supply pipe 49, the valve 51 provided in the middle path of the inert gas supply pipe 49, an in-line heater 61 provided on the downstream side of the valve 51, and a pair of inert gas nozzles 62.

The pair of inert gas nozzles 62 is line-connected to the inert gas supply pipe 49 branched on the downstream side of the in-line heater 61. In addition, the in-line heater 61 provided on the downstream side of the valve 51 can heat the inert gas supplied from the inert gas supply source 48 to a predetermined temperature. By electrically connecting the valve 51 to the control unit 300, opening and closing of the valve 51 can be controlled according to an operation command of the control unit 300. When the valve 51 is opened according to an operation command of the control unit 300, the inert gas can be supplied into the chamber 50. The supply amount of the inert gas can be adjusted by controlling the opening degree of the valve 51. In addition, the in-line heater 61 is also electrically connected to the control unit 300, and heating can be controlled according to an operation command of the control unit 300.

The depressurization portion includes at least an exhaust pump 63, an exhaust pipe 64, and an exhaust valve 65 provided in the middle path of the exhaust pipe 64. By electrically connecting the exhaust pump 63 to the control unit 300, exhaust by the exhaust pump 63 can be controlled according to an operation command of the control unit 300. In addition, by electrically connecting the exhaust valve 65 to the control unit 300, opening and closing of the exhaust valve 65 can be controlled according to an operation command of the control unit 300. When the atmosphere in the chamber 50 is controlled, the control unit 300 opens the valve 51 of the third inert gas supply portion. The inert gas is supplied from the inert gas supply source 48 into the chamber 50. In addition, the control unit 300 operates the exhaust pump 63 and then opens the exhaust valve 65. Thus, in addition to the supply of the inert gas into the chamber 50, the gas in the chamber 50 can be discharged by the exhaust pump 63, and the inside of the chamber 50 can be made into the inert gas atmosphere. As a result, the oxygen concentration in the chamber 50 can be reduced and the change in dissolved oxygen concentration of the treating liquid supplied to the surface Wf of the substrate W can be suppressed, and etching of the metal film 1 by the treating liquid can be further prevented.

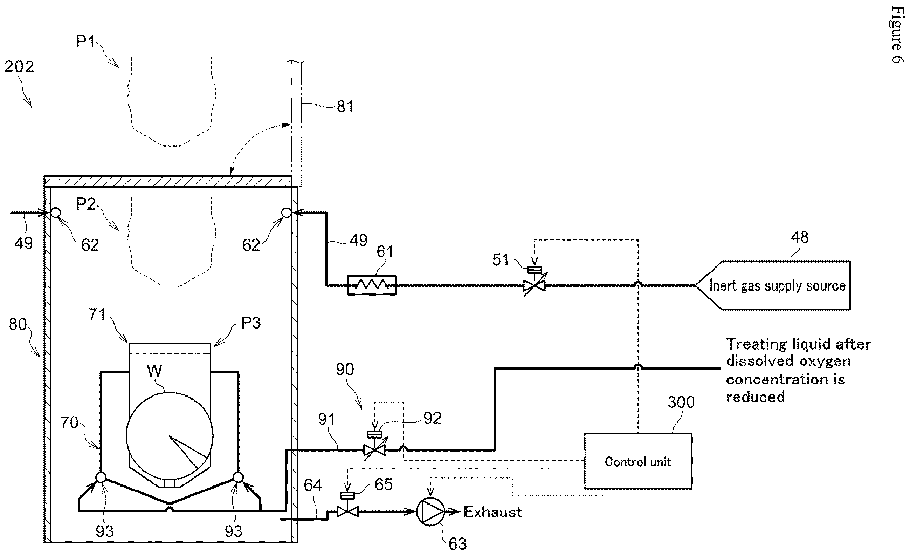

In the above description, the case where the film forming apparatus in the substrate treating apparatus of the present invention is a single wafer type in which the substrate W is treated one by one has been described as an example. However, the substrate treating apparatus of the present invention is not limited to this aspect, and as another aspect of the substrate treating apparatus of the present invention, the substrate treating apparatus can also be applied to a case where the film forming apparatus is in a batch type form in which a plurality of substrates is collectively treated. Hereinafter, a case where the substrate treating apparatus according to the present embodiment includes a batch type film forming apparatus will be described with reference to Fig. 6. Fig. 6 is an explanatory diagram schematically illustrating a batch type film forming apparatus 202 in the substrate treating apparatus. Note that, in the film forming apparatus 202 illustrated in Fig. 6, those having the same configuration as those of the film forming apparatuses 200 and 201 described above are denoted by the same reference numerals, and the description thereof is omitted.

As illustrated in Fig. 6, the film forming apparatus 202 includes at least a treatment tank 70 capable of storing the treating liquid in the tank and accommodating a plurality of substrates W in a state of being simultaneously immersed in the treating liquid, a liquid feed portion 90 that supplies the treating liquid into the tank of the treatment tank 70, a lifter 71 capable of holding and moving the plurality of substrates W, a chamber 80 surrounding the periphery of the treatment tank 70, a third inert gas supply portion that supplies an inert gas into the chamber 80, and a depressurization portion that exhausts a gas in the chamber 80.

The treatment tank 70 can store the treating liquid after the reduction in dissolved oxygen concentration in the tank, and is disposed on the downstream side of the treating liquid supply apparatus 100 (more specifically, the first storage portion 21a and the second storage portion 21b). In addition, the treatment tank 70 can accommodate the plurality of substrates W in an erected state (standing orientation). The erected state (standing orientation) means a state in which the substrate W is held such that the surface Wf of the substrate W is substantially perpendicular to the horizontal plane. By accommodating the substrate W in the treatment tank 70 in which the treating liquid is stored, the substrate W can be immersed in the treating liquid.

The lifter 71 can hold the plurality of substrates W in a standing orientation. The lifter 71 is movable in the up-down direction by a lift mechanism, which is not illustrated. The lifter 71 moves the plurality of held substrates W over an out-of-chamber standby position P1 outside the chamber 80 and above the chamber 80, an out-of-tank position P2 inside the chamber 80 and above the treatment tank 70, and an in-tank position P3 inside the chamber 80 and inside the treatment tank 70.

The chamber 80 includes an openable and closable upper cover 81 at an upper portion of the chamber 80. When the upper cover 81 is opened, the lifter 71 holding the plurality of substrates W enters the chamber 80, and the plurality of substrates W held in an erected state can be moved in the up-down direction between the out-of-chamber standby position P1 and the position in the chamber 80.

The liquid feed portion 90 supplies the treating liquid after the reduction in dissolved oxygen concentration supplied from the treating liquid supply apparatus 100 into the treatment tank 70. The liquid feed portion 90 includes a supply pipe 91 line-connected to the third discharge pipe 27c of the treating liquid supply apparatus 100, a valve 92 provided in the middle of the line of the supply pipe 91, and two ejection pipes 93 line-connected to the supply pipe 91 and capable of ejecting the treating liquid into the treatment tank 70. The two ejection pipes 93 have a long axis along a direction (paper surface direction) in which the plurality of substrates W held by the lifter 71 is aligned, and are provided at the bottom portion of the treatment tank 70. By electrically connecting the valve 92 to the control unit 300, opening and closing of the valve 92 can be controlled according to an operation command of the control unit 300. When the valve 92 is opened according to an operation command of the control unit 300, the treating liquid can be ejected from the ejection pipes 93 into the treatment tank 70.

As described above, the third inert gas supply portion includes the inert gas supply source 48, the pump (not illustrated) for pressurizing the inert gas, the inert gas supply pipe 49, the valve 51 provided in the middle path of the inert gas supply pipe 49, the in-line heater 61 provided on the downstream side of the valve 51, and the pair of inert gas nozzles 62.

As described above, the depressurization portion includes at least the exhaust pump 63, the exhaust pipe 64, and the exhaust valve 65 provided in the middle path of the exhaust pipe 64.

The third inert gas supply portion and the depressurization portion can control the atmosphere in the chamber 80. The third inert gas supply portion and the depressurization portion can form the inert gas atmosphere in the chamber 80. When the inert gas atmosphere is formed in the chamber 80, the control unit 300 opens the valve 51 of the third inert gas supply portion. The inert gas is supplied from the inert gas supply source 48 into the chamber 80. In addition, the control unit 300 operates the exhaust pump 63. Next, the control unit 300 opens the exhaust valve 65. Then, in addition to the supply of the inert gas into the chamber 80, the gas in the chamber 80 is discharged by the exhaust pump 63. As a result, the inert gas atmosphere is formed in the chamber 80.

In addition, when the atmosphere in the chamber 80 is controlled, the third inert gas supply portion can supply the inert gas heated by the in-line heater 61 into the chamber 80. Thus, it is possible to further promote drying of the substrate W that has been pulled up from the treating liquid in the treatment tank 70 and to which the treating liquid adheres.

Next, the operation of the above-described batch type film forming apparatus 202 will be described. The upper cover 81 at the upper portion of the chamber 80 is opened. Next, the lifter 71 enters the chamber 80 and moves the plurality of untreated substrates W held in the erected state from the out-of-chamber standby position P1 outside the chamber 80 to the out-of-tank position P2 inside the chamber 80. Then, the upper cover 81 closes the chamber 80.

The control unit 300 opens the valve 51 of the third inert gas supply portion. The inert gas is supplied from the inert gas supply source 48 into the chamber 80. The control unit 300 operates the exhaust pump 63. Next, the control unit 300 opens the exhaust valve 65. Thus, in addition to the supply of the inert gas into the chamber 80, the gas in the chamber 80 is discharged by the exhaust pump 63. Then, the inside of the chamber 80 becomes the inert gas atmosphere.

The control unit 300 opens the valve 92. The treating liquid after the reduction in dissolved oxygen concentration supplied from the treating liquid supply apparatus 100 is ejected from the ejection pipes 93 into the treatment tank 70. Thus, the treating liquid ejected into the treatment tank 70 is stored in the treatment tank 70.

The lifter 71 moves the plurality of held substrates W from the out-of-tank position P2 above the treatment tank 70 to the in-tank position P3 in the treatment tank 70. Then, the plurality of substrates W held by the lifter 71 is accommodated in the treatment tank 70 in which the treating liquid is stored. The plurality of substrates W held by the lifter 71 is immersed in the treating liquid stored in the treatment tank 70. Thus, the treating liquid after the reduction in dissolved oxygen concentration comes into contact with the surfaces Wf of the plurality of substrates W. When the treating liquid comes into contact with the surface Wf of the substrate W, the SAM 4 is formed in the metal film formed region where the metal film 1 is formed on the surface Wf of the substrate W.

Subsequently, the lifter 71 moves the plurality of held substrates W from the in-tank position P3 to the out-of-tank position P2. Thus, the plurality of substrates W immersed in the treating liquid is pulled up from the treatment tank 70. The plurality of substrates W held by the lifter 71 is exposed from the treating liquid stored in the treatment tank 70 to the inert gas atmosphere formed in the chamber 80. The treating liquid adhering to and remaining on the surface Wf of the substrate W is vaporized by being exposed in the inert gas atmosphere. As a result, the surface Wf of the substrate W is dried. The plurality of substrates W held by the lifter 71 is dried, for example, at the out-of-tank position P2.

The control unit 300 stops the operation of the exhaust pump 63. The control unit 300 closes the exhaust valve 65. Further, the control unit 300 closes the valve 51 of the third inert gas supply portion. Thus, the control of the atmosphere in the chamber 80 is stopped.

The upper cover 81 at the upper portion of the chamber 80 is opened. The lifter 71 moves from the out-of-tank position P2 to the out-of-chamber standby position P1. Thus, the plurality of substrates W is unloaded from the chamber 80.

As described above, in the batch type film forming apparatus 202, the oxygen concentration in the chamber 80 can be reduced by setting the inert gas atmosphere in the chamber 80. In addition, by reducing the oxygen concentration in the chamber 80, it is possible to suppress a change in dissolved oxygen concentration of the treating liquid stored in the treatment tank 70 and maintain the state in which the dissolved oxygen concentration is reduced. As a result, etching of the metal film 1 by the treating liquid can be further prevented. In addition, it is possible to suppress a change in dissolved oxygen concentration of the treating liquid adhering to and remaining on the surface Wf of the substrate W after being pulled up from the treatment tank 70. Thus, etching of the metal film 1 by the treating liquid remaining on the surface Wf of the substrate W can be further prevented.

In addition, in the batch type film forming apparatus 202, the third inert gas supply portion and the depressurization portion control the atmosphere in the chamber 80, so that the drying of the substrate W to which the treating liquid adheres after pulling up from the treatment tank 70 can also be promoted. In addition, by forming the inert gas atmosphere in the chamber 80, the third inert gas supply portion and the depressurization portion can promote drying of the substrate W by vaporization of the treating liquid attached to the surface Wf of the substrate W. Note that the plurality of substrates W held by the lifter 71 is dried, for example, at the out-of-tank position P2.

In addition, when the atmosphere in the chamber 80 is controlled, the third inert gas supply portion can supply the inert gas heated by the in-line heater 61 into the chamber 80. Thus, it is possible to further promote drying of the substrate W to which the treating liquid adheres.

### [Control Unit]

The control unit 300 is electrically connected to each portion of the substrate treating apparatus 10 and controls the operation of each portion. The control unit 300 includes a computer having an arithmetic processing unit and a storage unit. As the arithmetic processing unit, a CPU that performs various arithmetic processing is used. In addition, the storage unit includes ROM that is read-only memory for storing a substrate treating program, RAM that is readable and writable memory for storing various types of information, and a magnetic disk for storing control software, data, and the like. In the magnetic disk, substrate treating conditions including conditions for treatment of reducing the dissolved oxygen concentration of the treating liquid, supply of the inert gas, conditions for forming the SAM 4, and the like are stored in advance. The CPU reads the substrate treating conditions into the RAM, and controls each portion of the substrate treating apparatus 10 according to the contents.

### (Other Matters)

The treating liquid supply apparatus of the present embodiment may be used in various apparatuses other than the substrate treating apparatus, or may be used alone.

In the above description, the most preferred embodiment of the present invention has been described. However, the present invention is not limited to the embodiment. Each configuration in the above-described embodiment and each modification can be changed, modified, replaced, added, deleted, and combined within a range not contradictory to each other.

### EXAMPLES

Hereinafter, preferred examples of this invention will be exemplarily described in detail. However, the materials, blending amounts, conditions, and the like described in the examples are not to limit the scope of this invention only to the materials, blending amounts, conditions, and the like unless otherwise limited.

### (Example 1)

### [Preparation of Treating liquid and Treatment for Reducing Dissolved Oxygen Concentration]

Octadecylphosphonic acid (CH₃(CH₂)₁₇P(=O)(OH)₂) as an SAM forming material was dissolved in an ethanol solvent to prepare a treating liquid according to the present example. The concentration of octadecylphosphonic acid was 0.04 mass% with respect to the total mass of the treating liquid.

Next, the dissolved oxygen concentration of the treating liquid immediately after preparation was measured using a dissolved oxygen meter (trade name: Field type multi-digital water quality meter LAQUA WQ-310, manufactured by HORIBA, Ltd.). As a result, the initial dissolved oxygen concentration of the treating liquid was 6000 ppb.

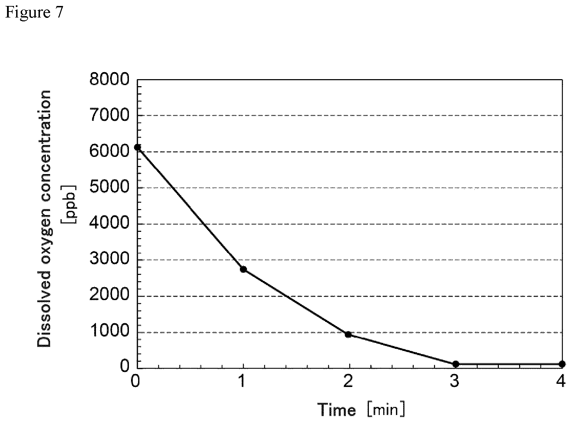

Subsequently, the treating liquid was subjected to a treatment for reducing the dissolved oxygen concentration in a glow box. In the treatment for reducing the dissolved oxygen concentration, first, the inside of the glow box was brought into a nitrogen gas atmosphere so that the oxygen concentration was less than 0.1%, and then nitrogen gas was supplied into the treating liquid placed in the container to perform bubbling. Bubbling with nitrogen gas was performed under the condition of a bubbling time (nitrogen gas supply time) of five minutes. Fig. 7 illustrates a graph illustrating a relationship between the dissolved oxygen concentration of treating liquid and the bubbling time. The dissolved oxygen concentration of the treating liquid after the treatment for reducing the dissolved oxygen concentration was measured using the dissolved oxygen meter described above. As a result, the dissolved oxygen concentration of the treating liquid after the reduction in dissolved oxygen concentration was 100 ppb.

### [Formation and Removal of SAM]

The SAM was formed on the surface of the substrate using the treating liquid after the treatment for reducing the dissolved oxygen concentration. Specifically, first, a substrate having an interlayer insulating film made of a SiO₂ film (film thickness 200 nm) in which a trench having a wiring width of 100 nm is formed and having a Cu film (film thickness 200 nm) as a metal film embedded in the trench was prepared.

Next, the treating liquid after the treatment for reducing the dissolved oxygen concentration was applied to the surface of the substrate to form the SAM in which octadecylphosphonic acid was adsorbed on the Cu film. Subsequently, the SAM on the Cu film was irradiated with ultraviolet rays, and then brought into contact with an acetic acid solution to remove the SAM, thereby preparing a sample according to the present example.

### (Comparative Example 1)

In the present comparative example, the treating liquid was not subjected to the treatment for reducing the dissolved oxygen concentration. Except for the above, in the same manner as in Example 1, the SAM was formed on the Cu film and the SAM was removed to prepare a substrate sample according to the present comparative example. Note that the initial dissolved oxygen concentration of the treating liquid was 6000 ppb.

### (Measurement of Surface Roughness)

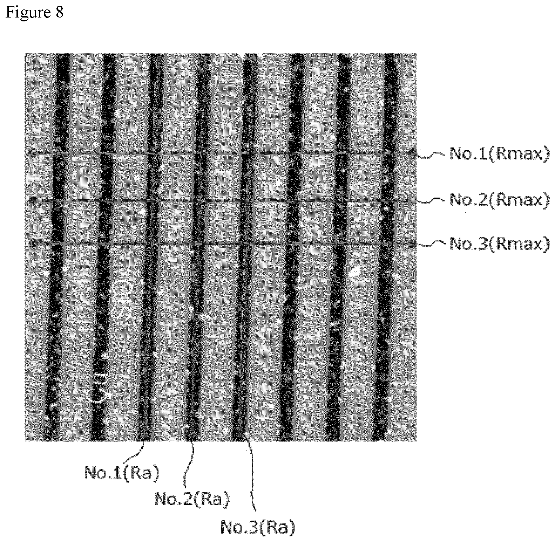

In the substrate before the formation of the SAM and the substrate samples according to Example 1 and Comparative Example 1, the centerline average roughness Ra and the maximum height Rmax were measured. Atomic force microscope ((AFM), trade name: Dimension ICON-PT type, manufactured by Bruker Japan Co., Ltd.) was used for the measurement. In addition, in the measurement of Ra, as illustrated in Fig. 8, three points in the metal film formed regions Nos. 1 to 3 where the Cu film was formed were measured, and an average value thereof was calculated. For the measurement of Rmax, as illustrated in Fig. 8, three points in the regions Nos. 1 to 3 perpendicular to the extending direction of the metal film formed region and the metal film non-formed region were measured, and an average value thereof was calculated. The results are illustrated in Table 1. Note that Fig. 8 is an electron micrograph illustrating a surface state of a substrate sample according to Example 1 of the present invention.

**[Table 1]**

| | | Substrate before formation of SAM | Comparative Example 1 | Example 1 |
|---|---|---|---|---|
| Ra (nm) | No.1 | 3.0 | 2.9 | 1.7 |
| | No.2 | 1.8 | 3.0 | 2.5 |
| | No.3 | 2.7 | 2.5 | 2.0 |
| | **Average value** | **2.5** | **2.8** | **2.1** |
| Rmax (nm) | No.1 | 11.8 | 16.3 | 14.4 |
| | No.2 | 14.4 | 16.3 | 14.2 |
| | No.3 | 15.0 | 12.8 | 12.0 |
| | **Average value** | **13.7** | **15.1** | **13.5** |

As can be seen from Table 1, in Comparative Example 1, the SAM was formed by using the treating liquid having a dissolved oxygen concentration of 6000 ppb, and it was confirmed that the value of the centerline average roughness Ra of the Cu film surface was larger than that of the substrate before the formation of the SAM. In addition, the value of the maximum height Rmax was also large, and it was confirmed that the step between the Cu film and the SiO₂ film was larger. On the other hand, in Example 1, the SAM was formed by using the treating liquid having a dissolved oxygen concentration reduced to 100 ppb, and the value of the centerline average roughness Ra of the Cu film surface was reduced as compared with the substrate before the formation of the SAM and the substrate according to Comparative Example 1. Further, the value of the maximum height Rmax was also reduced as compared with the substrate before the formation of the SAM and the substrate according to Comparative Example 1, and it was confirmed that the step between the Cu film and the SiO₂ film was reduced. Thus, it was confirmed that the oxidation and etching of the Cu film can be suppressed by using the treating liquid having a reduced dissolved oxygen concentration when the SAM is formed on the surface of the Cu film.

### DESCRIPTION OF REFERENCE SIGNS

1: Metal film, 2: Insulating film, 3: SAM forming material (self-assembled monolayer forming material), 4: Self-assembled monolayer (SAM), 5: Film, 10: Substrate treating apparatus, 11: Treating liquid tank, 12: Pressurization portion, 13: Pipe, 13a: First pipe, 13b: Second pipe, 14: Nitrogen gas supply pipe, 15: Valve, 16: Nitrogen gas supply source, 16a: First valve, 16b: Second valve, 21a: First storage portion, 21b: Second storage portion, 22: Inert gas supply pipe, 22a: First inert gas supply pipe, 22b: Second inert gas supply pipe, 22c: First branch pipe, 22d: Second branch pipe, 23: Valve, 23a: First upstream valve, 23b: Second upstream valve, 24a: First downstream valve, 24b: Second downstream valve, 25a: First discharge pipe, 25b: Second discharge pipe, 26a: First exhaust valve, 26b: Second exhaust valve, 27a: First discharge pipe, 27b: Second discharge pipe, 27c: Third discharge pipe, 28a: First discharge valve, 28b: Second discharge valve, 28c: Third discharge valve, 29, 48: Inert gas supply source, 30: Substrate holding portion, 40: Supply portion, 41: Opposing member, 42: Rotation support shaft, 43: Insertion shaft, 44: Lower surface, 46: Treating liquid supply path, 47: Inert gas supply path, 49: Inert gas supply pipe, 50, 80: Chamber, 51: Valve, 52: Space, 53: Supply portion rotation mechanism, 54: Supply portion lift mechanism, 60: Dispersion prevention cup, 61: In-line heater, 62: Inert gas nozzle, 63: Exhaust pump, 64: Exhaust pipe, 65: Exhaust valve, 66: Nozzle, 70: Treatment tank, 90: Liquid feed portion, 100: Treating liquid supply apparatus, 200, 201, 202: Film forming apparatus, 300: Control unit, S101: Preparation step, S102: Dissolved oxygen concentration reduction step, S103: Self-assembled monolayer (SAM) forming step, S104: Film forming step, S105: Removal step, W: Substrate, Wf: Surface of substrate

## Claims

1. A substrate treating method for treating a substrate including, on a surface, a metal film formed region where a metal film is formed and a metal film non-formed region where the metal film is not formed, the substrate treating method comprising:
a dissolved oxygen concentration reduction step of reducing a dissolved oxygen concentration of a treating liquid containing a material for forming a self-assembled monolayer; and
a self-assembled monolayer forming step of forming the self-assembled monolayer on the metal film in the metal film formed region while suppressing oxidation of the metal film by bringing the treating liquid after the dissolved oxygen concentration reduction step at least into contact with the surface of the substrate.

2. The substrate treating method according to claim 1, wherein the dissolved oxygen concentration reduction step reduces the dissolved oxygen concentration of the treating liquid by bubbling an inert gas in the treating liquid.

3. The substrate treating method according to claim 2, wherein the dissolved oxygen concentration reduction step is performed under an inert gas atmosphere.

4. The substrate treating method according to any one of claims 1 to 3, wherein the self-assembled monolayer forming step is performed under an atmosphere in which the dissolved oxygen concentration of the treating liquid after the dissolved oxygen concentration is reduced is maintained or reduced.

5. The substrate treating method according to any one of claims 1 to 4, wherein the dissolved oxygen concentration of the treating liquid after the dissolved oxygen concentration reduction step is less than 100 ppb.

6. The substrate treating method according to any one of claims 1 to 5, wherein the treating liquid contains a phosphonic acid compound having a phosphonic acid group capable of adsorbing a surface of the metal film, and a solvent.

7. The substrate treating method according to any one of claims 1 to 6, further comprising:
a film forming step of selectively forming a film in the metal film non-formed region using the self-assembled monolayer formed in the metal film formed region as a protective film after the self-assembled monolayer forming step; and
a removal step of exposing the metal film by removing the self-assembled monolayer formed in the metal film formed region after the film forming step.

8. A substrate treating apparatus for treating a substrate including, on a surface, a metal film formed region where a metal film is formed and a metal film non-formed region where the metal film is not formed, the substrate treating apparatus comprising:
a storage portion that stores a treating liquid containing a material for forming a self-assembled monolayer;
a first inert gas supply portion that supplies an inert gas into the treating liquid stored in the storage portion, and reduces a dissolved oxygen concentration of the treating liquid; and
a supply portion that supplies the treating liquid after the dissolved oxygen concentration is reduced to the surface of the substrate, and forms the self-assembled monolayer on the metal film in the metal film formed region while suppressing oxidation of the metal film.

9. A substrate treating apparatus for collectively treating a plurality of substrates each including, on a surface, a metal film formed region where a metal film is formed and a metal film non-formed region where the metal film is not formed, the substrate treating apparatus comprising:
a storage portion that stores a treating liquid containing a material for forming a self-assembled monolayer;
a first inert gas supply portion that supplies an inert gas into the treating liquid stored in the storage portion, and reduces a dissolved oxygen concentration of the treating liquid;
a liquid feed portion that feeds the treating liquid after the dissolved oxygen concentration is reduced from the storage portion toward a downstream side; and
a treatment tank that stores the treating liquid after the dissolved oxygen concentration is reduced sent by the liquid feed portion, collectively immerses the plurality of substrates in the treating liquid, and forms the self-assembled monolayer on the metal film in the metal film formed region on the surface of each substrate while suppressing oxidation of the metal film.

10. The substrate treating apparatus according to claim 8 or 9, wherein the first inert gas supply portion brings an inside of the storage portion into an inert gas atmosphere by supplying the inert gas into the storage portion, and reduces the dissolved oxygen concentration of the treating liquid by supplying the inert gas into the treating liquid stored in the storage portion.

11. The substrate treating apparatus according to claim 8, wherein
the supply portion further includes
an opposing member that closely faces the surface of the substrate at an arbitrary separation distance; and
a second inert gas supply portion that supplies the inert gas toward a space between the surface of the substrate and the opposing member,
the second inert gas supply portion supplies the inert gas toward the space to bring the space into an atmosphere in which the dissolved oxygen concentration of the treating liquid after the dissolved oxygen concentration is reduced is maintained or reduced, and
the supply portion supplies the treating liquid after the dissolved oxygen concentration is reduced to the surface of the substrate under an atmosphere in which the dissolved oxygen concentration of the treating liquid is maintained or reduced.

12. The substrate treating apparatus according to claim 8, further comprising:
a chamber for supplying the treating liquid to the surface of the substrate by the supply portion in a sealed space;
a third inert gas supply portion that supplies the inert gas into the chamber; and
a depressurization portion that exhausts gas in the chamber, wherein
the third inert gas supply portion supplies the inert gas into the chamber, and the depressurization portion exhausts the gas in the chamber, so that an inside of the chamber is brought into an atmosphere in which the dissolved oxygen concentration of the treating liquid after the dissolved oxygen concentration is reduced is maintained or reduced, and
the supply portion supplies the treating liquid after the dissolved oxygen concentration is reduced to the surface of the substrate under an atmosphere in which the dissolved oxygen concentration of the treating liquid is maintained or reduced.

13. The substrate treating apparatus according to any one of claims 8 to 12, further comprising: a control unit that controls the first inert gas supply portion so that the dissolved oxygen concentration of the treating liquid after the dissolved oxygen concentration is reduced is less than 100 ppb.
